# EUROPEAN PATENT SPECIFICATION

(11) **EP 4 277 082 B1**
(45) Date of publication and mention of the grant of the patent: **24.09.2025**
(21) Application number: 22173037.7
(22) Date of filing: 12.05.2022
(51) Int. Cl.: H02J 13/00, H02J 3/00, H02H 1/00, G01R 19/25

(54) **CONTROL METHOD, AND CONTROL SYSTEM FOR A SUBSTATION**
STEUERVERFAHREN UND STEUERSYSTEM FÜR EINE UNTERSTATION
PROCÉDÉ DE COMMANDE ET SYSTÈME DE COMMANDE D'UNE SOUS-STATION

(43) Date of publication of application: 15.11.2023
(73) Proprietor: ABB SCHWEIZ AG, 5400 Baden (CH)
(72) Inventor: BIRKE, Robert, 8802 Kilchberg (CH); SCHOENBORN, Sandro, 4059 Basel (CH); SIVANTHI, Thanikesavan, 5303 Würenlingen (CH); HOVILA, Petri, 65320 Vaasa (FI)
(74) Representative: Zimmermann & Partner Patentanwälte mbB

(56) References cited:
- US-A1- 2015 318 739
- US-A1- 2018 089 057

## Description

### TECHNICAL FIELD

The disclosure generally relates to a control method for a control system in a substation, and a control system for a substation.

### BACKGROUND

As automation of substations is advancing, measures for reliable fault identification and troubleshooting are vital. Besides reliability, swiftness of troubleshooting also plays an important role as it has been observed that reaction time has an immediate effect on device equipment and supply security, reaction time referring to the time period between fault occurrence and fault clearance. For instance, overcurrents can build up while a fault occurs, such as a short-circuit, until the fault is resolved by troubleshooting. Thus, length of reaction time has an immediate effect on the magnitude overcurrents build up to. Accordingly, reducing the reaction time for troubleshooting limits the current magnitude.

Device equipment for fault isolation and restoration, such as switchgear, needs to be adapted to resist respective overcurrent magnitudes. Consequently, by reducing reaction time, existing device equipment can be preserved while new equipment can be developed to resist smaller overcurrents, thereby reducing equipment size and costs.

### PRIOR ART

According to the conventional technology, for example, a central protection device is provided within a substation. The device centralizes all protection and control functionality into a single entity on the substation level which allows for a cost-efficient operation. The protection device complies with standardized requirements, e.g. IEC 61850, that define communication protocols between the protection device and equipment located within the substation. The requirements also define a reaction time, i.e. one-way delay, which must not be exceeded when communicating a control command for troubleshooting. It is, however, favorable to further reduce the reaction time for preserving existing equipment, thereby extending its lifetime, and also for development of new equipment. US 2015/318739 A1 discloses a protective control system in a substation.

### SUMMARY OF THE DISCLOSURE

According to an aspect, a control method is provided. The control method is configured for a control system in a substation. The control system comprises a substation feeder, an intelligent electronic device, IED, a merging unit, and BUS network which connects the IED and the merging unit. The control method includes providing measurement signals by the substation feeder to the merging unit. Further, the method includes transmitting, by the merging unit, measurement data based on the measurement signals of the substation feeder to the IED via the BUS network, and identifying, by the IED, a fault condition based on the measurement data, the fault condition being indicative of an actual or potentially forthcoming fault. The method also comprises transmitting, by the IED, a conditional control command to the merging unit via the BUS network, the conditional control command comprising a control measure and a condition for executing the control measure, determining, by the merging unit, whether the condition of the conditional control command is met, and if so initiating, by the merging unit, the control measure of the substation feeder circuit.

An IED, as used herein, refers to a real-time protection and control entity of a substation. A substation may have multiple decentralized IEDs, or a single, centralized IED. In the latter case, the IED benefits from a more global view spanning multiple/ all merging units, while also providing substation-wide visibility. Yet, a centralized IED forfeits proximity to the sensors and switchgear bay of feeders which implies longer decision paths, including both communication and decision logic, and thereby reaction times.

The IED may provide a human-machine interface (HMI) for input by a user and displaying and/or providing data to a user. The IED may also allow for disturbance recordings for the entire substation. The IED typically receives measurement data from the merging unit via the BUS network. It includes logic to process the measurement data in order to identify a fault condition and to issue a conditional control command. The logic includes both, hardware components, e.g. a microprocessor, and software components. Besides issuing a conditional control command, the IED may also be configured to issue a control command without a condition that the merging unit executes in any case.

A merging unit, as used herein, refers to an entity which is configured to merging measurement signals from the feeder into measurement data of a standard digital output format. The merging unit may include converting analog measurement signals into digital measurement data. The merging unit may also include sampling the measurement signal and further data processing, such as filtering. The merging unit may provide the measurement data in digital data packets such as IP packets (e.g., TCP/IP packets such as Ethernet frames) for communication over the BUS network. The data packets may be unicast, multicast or broadcast frames.

The BUS network may be an IP packet-based network such as an Ethernet-based network, for instance a local area network (LAN), or internet-based, for instance a wide area network (WAN), the latter using IP in some cases. The BUS Network can also be based on other technologies such as MPLS (Multiprotocol Label Switching).

The condition of the conditional control command typically comprises a control decision model based on the measurement data. The decision path between the merging unit and the switchgear bay is generally shorter than between the IED and the switchgear bay. Thus, there may be a reduction in reaction time depending on where the decision model is executed. The decision path may be adapted accordingly, for instance in systems with distributed set-ups or non-local components. Therefore, control models are provided that vary with respect to where parts or the entire control model is executed.

In some embodiments, the control model relies on communication between the IED and the merging unit which complies to a standard communication protocol, such as the IEC 61850 standard for communication and interoperability in the digital substations.

Accordingly, the IED may issue the conditional control command complying to a control model defined as Generic Object Oriented Substation Events (GOOSE) by the IEC 61850. Irrespective of whether or not the conditional command is a GOOSE command, the conditional command may adhere to one or more of the following characteristics of GOOSE: GOOSE requires the IED to transmit the conditional control commands within a typical period of less than 10 milliseconds (e.g., 3 milliseconds or 4 milliseconds) to the merging unit. GOOSE may adhere to a publisher/subscriber model, in which a publisher transmits unacknowledged data to subscribers. In the case of an event, a burst of messages with new data is transmitted thereby minimizing the chance of message loss. As GOOSE-commands are published under a topic, the subscriber, i.e. the merging unit, filters only messages identified by a subscribed topic. A GOOSE command may include, for instance, a specified control measure, such as closing a circuit breaker.

Alternatively, communication between the IED and the merging unit adheres to a hierarchical control model. In some cases, such communication may be implemented as an extension to the above-described GOOSE control model. As an example, a GOOSE command may be provided with a condition specifying under what condition the merging unit is to carry out the GOOSE command. Such an extended GOOSE command may include, for instance, a specified control measure plus a conditional instruction, such as an elapse of a time period to execute the control measure.

The hierarchical control model may further enable the IED to dynamically transmit small pieces of flexible programming code, referred to herein as codelet, over the BUS network and to install such a codelet at the merging unit. Such codelets are configured to be executed at the merging unit. The merging unit processes this codelet to take simple decisions locally. Codelets may comprise functionalities such as condition-based status updates, if-else decision trees evaluating multiple signals, or even a trained machine learning model. Also, the codelets may provide a potential action to take. The codelets may be generic or tuned to one or more target merging units. As the merging unit is arranged in proximity to the feeder with its sensors and switchgear bay, the decision path and, thereby, the reaction time is reduced. As a result, both benefits, the IED's global view and the short path from the merging units to the switchgear bay are combined. Moreover, delegating tasks to the merging unit also frees the IED from having to take actions at the desired point in time allowing it to process another task. This provides an opportunity for the IED to outsource actions, thereby providing additional processing resources.

The merging unit may provide the measurement data complying to sampled values (SV) or sampled measure values (SMV), the latter being defined by the IEC 61850-9-2 standard. The measurement data may be published by the merging unit at a specific rate for a specific grid frequency, for instance at 4000 frames per second for a grid frequency of 50 Hz and 4800 frames per second for 60 Hz. SMV may adhere to a publisher/subscriber model, in which a publisher transmits unacknowledged data to subscribers.

The merging unit typically offers a physical interface to a switchgear bay of the feeder. The switchgear bay may be configured for executing a control measure initiated by the merging unit. A control measure, as used herein, typically includes an operation, in particular a protective operation, within the substation feeder circuit by the switchgear bay, such as separating a feeder from the substation if the feeder has a fault, or closing a breaker of the substation feeder circuit after a fault is resolved, in particular tripping circuit breakers, or also raising/lowering tap position in order to maintain desired voltage level. The switchgear bay may provide the hardware equipment to execute a respective control measure.

Fault condition being indicative of a potentially forthcoming fault, is used herein to describe anomalies in the measurement data, such as a loss of voltage, overcurrent or frequency deviation.

In one embodiment, the control system comprises at least one second merging unit and at least one second substation feeder. The BUS network connects the IED and the at least one second merging unit. The method further comprises providing measurement signals by the at least one second substation feeder to the at least one second merging unit. The method also comprises transmitting, by the at least one second merging unit, second measurement data based on the measurement signals of the at least one second substation feeder to the IED via the BUS network.

In this embodiment, the method may further comprise identifying, by the protection device, a second fault condition based on the second measurement data, the fault condition being indicative of a potentially forthcoming fault, and transmitting, by the protection device, a conditional control command to the at least one second merging unit via the BUS network. This enables the IED to take a more global perspective of multiple substation feeders and to derive therefrom a potential fault condition for a specific substation feeder and to instruct a respective merging unit.

In a further embodiment, transmitting the conditional control command via the BUS network complies with a hierarchical communication protocol. The merging unit is located at a lower hierarchical level than the IED within the hierarchical communication protocol. The measurement data may optionally also be transmitted via the BUS network, according to the hierarchical or to a non-hierarchical communication protocol.

In one embodiment, the control method further includes encoding the condition of the conditional control command in a codelet by the IED and transmitting the codelet by the IED to the merging unit via the BUS network. The method also includes processing the codelet by the merging unit. The merging unit may encompass a codelet interpreter for processing the codelet. For instance, the codelet may include a sequence of instructions that the merging unit executes. Such instructions may include functional statements such as "IF I > 100 A, Trip breaker, ENDIF".

In an alternative embodiment, the condition of the conditional control command comprises a specified reaction time period until initiation of the protection measure. Such a "timed" command is issued to execute a specific protection measure after expiration of the set reaction time. Devices in substations are typically synchronized and thereby refer to a common time. Thus, the reaction time of the "timed" command may be calculated based on the common reference frame.

Alternatively or additionally, the condition of the conditional control command comprises a specified fault threshold for the measurement data. In some cases, the condition comprises a specified fault threshold for the measurement data over a specified time period.

Alternatively or additionally, the condition of the conditional control command comprises a zero-crossing condition for a measured current and/or voltage.

Examples for specifying the condition may consider applications such as zero-point switching of a circuit breaker. Thereby, the merging unit may locally determine the moment when to initiate the control action, that is when an alternating current of the feeder passes through zero. That way, potential switching arcs and other hazards are prevented.

The measurement signals typically comprise at least one of a voltage signals, current signals, temperature signals, and frequency signals. The measurement data typically comprises at least one of a current data, voltage data, and frequency data based on the respective measurement signals.

In another embodiment, the control measure further comprises operating at least one switchgear bay of the substation. The switchgear bay preferably comprises at least one of a circuit breaker, a disconnector, load switch or switch disconnector. The switch disconnector may comprise common switch disconnectors or fuse switch disconnectors. The operating preferably comprising a control action.

In yet another embodiment, the control method further comprises identifying, by the IED, a no-fault condition based on the measurement data, the no-fault condition being indicative of the conditional control command being no longer necessary, and transmitting, by the IED, a cancel command for cancelling the conditional control command to the merging unit.

According to another aspect, a merging unit for a control system for a substation is provided. The merging unit comprises a feeder-facing interface for receiving the measurement signals from at least one substation feeder. The merging unit also comprises a signal converter for providing measurement data based on the measurement signals of the at least one substation feeder. Further, the merging unit has a BUS interface for transmitting the measurement data via a BUS network to an IED and for receiving a conditional control command from the IED. The conditional control command comprises a control measure and a condition for executing the control measure. The merging unit also comprises logic configured for determining whether the condition of the conditional control command is met, and if so, for initiating the control measure of the substation feeder circuit.

According to a further aspect, a control system for a substation is provided. The control system comprises at least one substation feeder with sensors for providing measurement signals, at least one merging unit, an IED, and a BUS network. The BUS network connects the at least one merging unit with the IED. The at least one merging unit has a feeder-facing interface for receiving the measurement signals from the at least one substation feeder, a signal converter for providing measurement data based on the measurement signals of the at least one substation feeder, and a BUS interface for transmitting the measurement data via the BUS network to the IED. The IED has a BUS interface for receiving the measurement data. The IED has also logic for identifying, based on the measurement data, a fault condition indicative of a potentially forthcoming fault and for providing a conditional control command. The BUS interface is configured for transmitting the conditional control command via the BUS network to the at least one merging unit. The conditional control command comprises a control measure and a condition for executing the control measure. The merging unit has logic configured for determining whether the condition of the conditional control command is met, and if so, for initiating the control measure of the substation feeder circuit.

Further features are derivable from the dependent claims.

In an embodiment, the BUS network between the IED and the merging unit complies with a hierarchical communication protocol. The at least one merging unit is located at a lower hierarchical level than the IED within the hierarchical communication protocol.

In an alternative embodiment, the conditional control command is encoded as a codelet, and the merging unit has logic configured for carrying out the codelet. The codelet may be precompiled or created on the fly by the IED. The codelet may be generic or targeting a specific merging unit or a group of merging units. The codelet may encompass functional statements, a compute graph or machine learning model used to take the decision on a control action.

In yet another embodiment, the control system further comprises at least one switchgear bay. The switchgear bay preferably comprises at least one of a circuit breaker, a disconnector, load switch or switch disconnector. The control measure preferably comprises a control action. The circuit breaker may be a gas-insulated or an air-insulated circuit breaker. The switchgear system may be configured for low voltage (up to, e.g. 1 KV), medium voltage (e.g. 3 KV to 36 KV) or high voltage (e.g. above 36 KV). The switchgear may use communication standards which are different from the IEC 61850 standard, for instance OPC-UA, MODBUS, IEC 60870, DNP3. These standards may be extended to carry a conditional control command and/or a codelet.

The control system is further configured for carrying out above-described method or parts thereof.

### BRIEF DESCRIPTION OF THE DRAWINGS

Fig. 1 illustrates a schematic diagram of a control method for a control system in a substation according to an embodiment;
Fig. 2 illustrates a schematic diagram of a BUS network of a substation complying with a hierarchical communication protocol according to an embodiment;
Fig. 3 illustrates a schematic circuit diagram of a control system for a substation according to embodiments described herein.

### DESCRIPTION OF EMBODIMENTS

In the following, embodiments are set forth to describe specific examples presented herein. The person skilled in the art will recognize that one or more other examples and/or variations of these examples may be practiced without all the specific details outlined below. Also, well known features may not be described in detail so as not to obscure the description of the examples herein. For the ease of illustration, like reference numerals are used in different figures to refer to the same elements or additional instances of the same element.

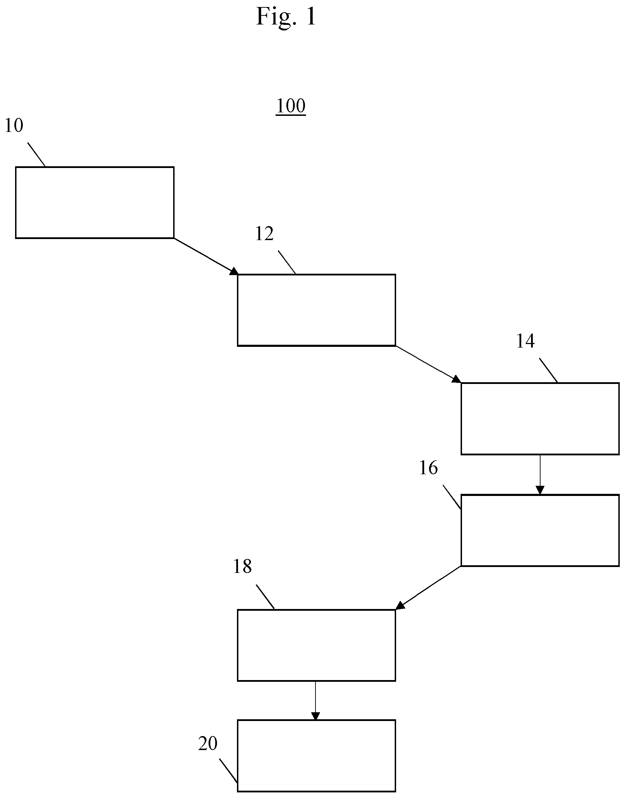

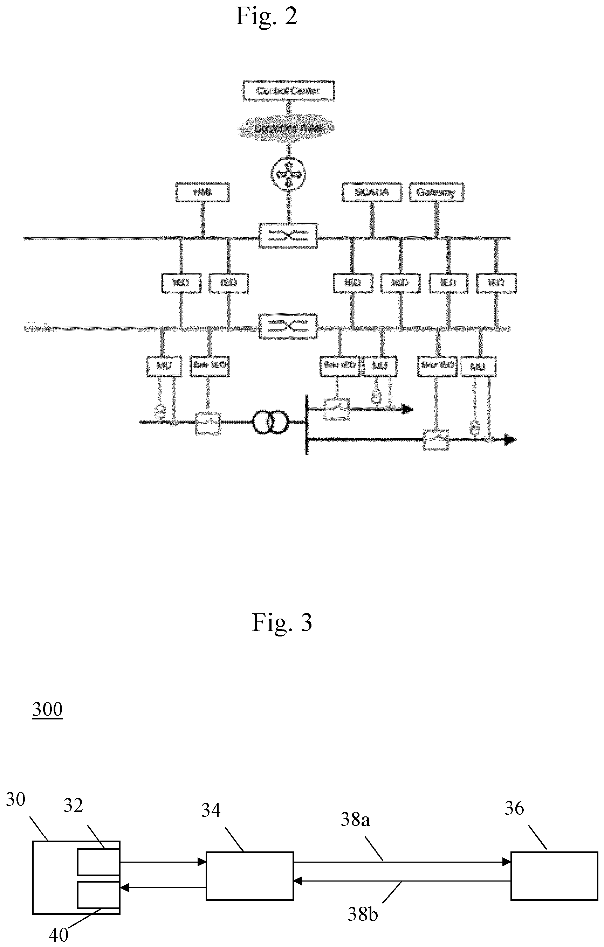

Referring now to the drawings, Fig. 1 illustrates a control method 100 for a control system in a substation. The control system and its components which include a substation feeder, an intelligent electronic device, IED, a merging unit, and BUS network connecting the IED and the merging unit are described in more detail with reference to Fig. 3 below. Fig. 1 with its horizontal arrangement of boxes is intended to illustrate the control system's component carrying out the respective method step. Thereby, the method step symbolized by the box furthest left is carried out by a substation feeder; the method steps symbolized by the middle boxes are carried out by the merging unit; while the method steps symbolized by the boxed furthest right are carried out by the IED.

The control method 100 comprises providing measurement signals 10 by the substation feeder to the merging unit. In step 12, the method provides for transmitting, by the merging unit, measurement data based on the measurement signals of the substation feeder to the IED via the BUS network. Next, the method foresees identifying 14, by the IED, a fault condition based on the measurement data, the fault condition being indicative of a potentially forthcoming fault, and transmitting 16, by the IED, a conditional control command to the merging unit via the BUS network 38a, 38b, the conditional control command comprising a control measure and a condition for executing the control measure. Lastly control method 100 provides for determining 18, by the merging unit, whether the condition of the conditional control command is met, and if so initiating 20, by the merging unit, the control measure of the substation feeder circuit.

Referring now to Fig. 2, a schematic diagram of a BUS network of a substation complying with a hierarchical communication protocol according to an embodiment of the present disclosure is illustrated. As shown, the hierarchical communication protocol connects different levels, with the merging units MU being allocated at a lower level and the IED being allocated at a higher level. Lastly, a human-machine interface HMI, supervisory control and data acquisition SCADA and/or gateway are allocated at the highest level. Although multiple IED are shown, some embodiments may provide for a single, centralized IED within entire substation. In this case, the IED provides for substation-wide visibility. The IED is configured to send and install codelet, via the hierarchical communication protocol, to a single or multiple merging units. The hierarchical communication protocol can be an extension to above-described GOOSE model, or any other suitable hierarchical protocol.

Referring now to Fig. 3, a schematic circuit diagram of a control system 300 for a substation according to the present disclosure is illustrated. The components of control system 300 include a substation feeder 30 with sensors 32 for providing measurement signals and a switchgear bay 40 for operating a control action. The switchgear bay is configured for operating a control action, such as to separate the feeder 30 from the substation if the feeder 30 is faulted. Likewise, the switchgear bay can close a breaker after a fault is resolved.

The control system 300 further includes a merging unit 34, an IED 36, and a BUS network 38a, 38b. Although only one merging unit is displayed, the principles described herein apply equally to a control system with more than one merging unit. The BUS network 38a, 38b connects the merging unit 34 with the IED 36. The BUS network provides for two connections 38a and 38b. Connection 38a serves for transmitting the measurement data, in some cases complying with SMV, to the IED 36, while connection 38b serves for transmitting the conditional control command to the merging unit by the IED, the conditional control command comprising a control measure and a condition for executing the control measure. In some cases, connection 38b complies with GOOSE, in other cases connection 38b complies with an extension to GOOSE such that a hierarchical communication protocol between the IED 36 and the merging unit 34 is established, in yet other cases, connection 38b complies to a hierarchical communication protocol irrespective of GOOSE.

Interfaces of the merging unit 34 and the IED 36 are not illustrated with separate reference sign for reasons of clarity, but are located at the arrows' endpoints, respectively. In particular, the merging unit 34 has a feeder-facing interface for receiving the measurement signals from the sensors 32 of the substation feeder 30 and for initiating control measure by the switchgear by 40. To connect to the BUS network, the merging unit 34 has a BUS interface for transmitting the measurement data via the BUS network to the IED 36 and for receiving the conditional control commands by the IED. The IED 36 also has a BUS interface for receiving the measurement data and for transmitting the conditional control command via the BUS network to the merging unit 34.

Embodiments and/or features described herein with respect to the control method may be implemented equally within the control system and vice versa.

## Claims

1. A control method (100) for a control system in a substation, the control system comprising a substation feeder (30), an intelligent electronic device, IED, (36), a merging unit (34), and BUS network (38a, 38b) connecting the IED (36) and the merging unit (34), the control method comprising:
- providing (10) measurement signals by the substation feeder (30) to the merging unit (34),
- transmitting (12), by the merging unit (34), measurement data based on the measurement signals of the substation feeder to the IED (36) via the BUS network (38a, 38b),
- identifying (14), by the IED (36), a fault condition based on the measurement data, the fault condition being indicative of a potentially forthcoming fault,
**characterised by**:
- transmitting (16), by the IED (36), a conditional control command to the merging unit (34) via the BUS network (38a, 38b), the conditional control command comprising a control measure and a condition for executing the control measure,
- determining (18), by the merging unit, whether the condition of the conditional control command is met, and if so
- initiating (20), by the merging unit, the control measure of the substation feeder circuit.

2. The control method of claim 1, wherein the control system comprises at least one second merging unit and at least one second substation feeder, the BUS network connecting the IED and the at least one second merging unit, the method further comprising:
- providing measurement signals by the at least one second substation feeder to the at least one second merging unit
- transmitting, by the at least one second merging unit, second measurement data based on the measurement signals of the at least one second substation feeder to the IED via the BUS network.

3. The control method of any of the previous claims, wherein transmitting the conditional control command via the BUS network complies with a hierarchical communication protocol, wherein the merging unit is located at a lower hierarchical level than the IED within the hierarchical communication protocol.

4. The control method of any of the previous claims, further comprising:
- encoding the condition of the conditional control command in a codelet by the IED and transmitting the codelet by the IED to the merging unit via the BUS network
- processing the codelet by the merging unit.

5. The control method of any of the preceding claims, wherein the condition of the conditional control command comprises a specified reaction time period until initiation of the protection measure.

6. The control method of any of the preceding claims, wherein the condition of the conditional control command comprises a specified fault threshold for the measurement data.

7. The control method of any of the preceding claims, wherein the condition of the conditional control command comprises a control decision model based on measurement data, the control decision model preferably comprising a zero-crossing condition for a measured current and/or voltage.

8. The control method of any of the previous claims, wherein the measurement signals comprise at least one of a voltage signals, current signals, temperature signals, and frequency signals.

9. The control method of any of the previous claims, wherein the control measure comprises operating at least one switchgear bay (40) of the substation, the switchgear bay preferably comprising at least one of a circuit breaker, a disconnector, load switch or switch disconnector, the operating preferably comprising a control action.

10. The control method of any of the previous claims, further comprising
- identifying (14), by the IED (36), a no-fault condition based on the measurement data, the no-fault condition being indicative of the conditional control command being no longer necessary, and
- transmitting, by the IED, a cancel command for cancelling the conditional control command to the merging unit.

11. A merging unit (34) for a control system for a substation, the merging unit comprising:
- a feeder-facing interface for receiving measurement signals from at least one substation feeder of the substation;
- a signal converter for providing measurement data based on the measurement signals of the at least one substation feeder;
- a BUS interface for transmitting the measurement data via a BUS network to an IED and for receiving a conditional control command from the IED,
**characterised in that** the conditional control command comprises a control measure and a condition for executing the control measure; and
**in that** the merging unit further comprises;
- logic configured for determining (18) whether the condition of the conditional control command is met, and if so, for initiating (20) the control measure of the substation feeder circuit.

12. A control system for a substation, the control system comprising:
- at least one substation feeder (30) with sensors (32) for providing measurement signals,
- at least one merging unit (34) according to claim 11,
- an IED (36); and
- a BUS network (38a, 38b) connecting the at least one merging unit (34) with the IED (36), wherein
the IED has a BUS interface for receiving the measurement data; logic for identifying, based on the measurement data, a fault condition indicative of a potentially forthcoming fault and for providing a conditional control command, wherein the BUS interface is configured for transmitting the conditional control command via the BUS network to the at least one merging unit.

13. The control system of claim 12, wherein the BUS network between the IED and the merging unit complies with a hierarchical communication protocol, wherein the at least one merging unit is located at a lower hierarchical level than the IED within the hierarchical communication protocol.

14. The control system of claim 12 or 13, wherein the conditional control command is encoded as a codelet, and wherein the merging unit has logic configured for carrying out the codelet.

15. The control system of any of claims 12 - 14, further comprising at least one switchgear bay, the switchgear bay preferably comprising at least one of a circuit breaker, a disconnector, load switch or switch disconnector, the control measure preferably comprising a control action.

## Patentansprüche

1. Steuerverfahren (100) für ein Steuersystem in einer Unterstation, wobei das Steuersystem eine Unterstationseinspeisung (30), eine intelligente elektronische Vorrichtung, IED, (36), eine Zusammenführungseinheit (34) und ein BUS-Netzwerk (38a, 38b), das die IED (36) und die Zusammenführungseinheit (34) verbindet, umfasst, wobei das Steuerverfahren umfasst:
- Bereitstellen (10) von Messsignalen durch die Unterstationseinspeisung (30) an die Zusammenführungseinheit (34),
- Übertragen (12), durch die Zusammenführungseinheit (34), von Messdaten basierend auf den Messsignalen der Unterstationseinspeisung an die IED (36) über das BUS-Netzwerk (38a, 38b),
- Identifizieren (14), durch die IED (36), einer Fehlerbedingung basierend auf den Messdaten, wobei die Fehlerbedingung einen potenziellen bevorstehenden Fehler angibt,
**gekennzeichnet durch**:
- Übertragen (16), durch die IED (36), eines bedingten Steuerbefehls an die Zusammenführungseinheit (34) über das BUS-Netzwerk (38a, 38b), wobei der bedingte Steuerbefehl eine Steuermaßnahme und eine Bedingung für die Ausführung der Steuermaßnahme umfasst,
- Bestimmen (18), durch die Zusammenführungseinheit, ob die Bedingung des bedingten Steuerbefehls erfüllt ist, und falls ja,
- Initiieren (20), durch die Zusammenführungseinheit, der Steuermaßnahme des Unterstationseinspeisungsstromkreises.

2. Steuerverfahren nach Anspruch 1, wobei das Steuersystem mindestens eine zweite Zusammenführungseinheit und mindestens eine zweite Unterstationseinspeisung umfasst, wobei das BUS-Netzwerk die IED und die mindestens eine zweite Zusammenführungseinheit verbindet, wobei das Verfahren ferner umfasst:
- Bereitstellen von Messsignalen durch die mindestens eine zweite Unterstationseinspeisung an die mindestens eine zweite Zusammenführungseinheit,
- Übertragen, durch die mindestens eine zweite Zusammenführungseinheit, zweiter Messdaten basierend auf den Messsignalen der mindestens einen zweiten Unterstationseinspeisung an die IED über das BUS-Netzwerk.

3. Steuerverfahren nach einem der vorhergehenden Ansprüche, wobei das Übertragen des bedingten Steuerbefehls über das BUS-Netzwerk einem hierarchischen Kommunikationsprotokoll entspricht, wobei sich die Zusammenführungseinheit an einer niedrigeren hierarchischen Ebene als die IED innerhalb des hierarchischen Kommunikationsprotokolls befindet.

4. Steuerverfahren nach einem der vorhergehenden Ansprüche, ferner umfassend:
- Codieren der Bedingung des bedingten Steuerbefehls in ein Codelet durch die IED und Übertragen des Codelets durch die IED an die Zusammenführungseinheit über das BUS-Netzwerk,
- Verarbeiten des Codelets durch die Zusammenführungseinheit.

5. Steuerverfahren nach einem der vorhergehenden Ansprüche, wobei die Bedingung des bedingten Steuerbefehls einen spezifizierten Reaktionszeitraum bis zur Initiierung der Schutzmaßnahme umfasst.

6. Steuerverfahren nach einem der vorhergehenden Ansprüche, wobei die Bedingung des bedingten Steuerbefehls eine spezifizierte Fehlerschwelle für die Messdaten umfasst.

7. Steuerverfahren nach einem der vorhergehenden Ansprüche, wobei die Bedingung des bedingten Steuerbefehls ein Steuerentscheidungsmodell basierend auf Messdaten umfasst, wobei das Steuerentscheidungsmodell vorzugsweise eine Nulldurchgangsbedingung für einen gemessenen Strom und/oder eine gemessene Spannung umfasst.

8. Steuerverfahren nach einem der vorhergehenden Ansprüche, wobei die Messsignale mindestens eines von Spannungssignalen, Stromsignalen, Temperatursignalen und Frequenzsignalen umfassen.

9. Steuerverfahren nach einem der vorhergehenden Ansprüche, wobei die Steuermaßnahme das Betreiben mindestens eines Schaltanlagenfeldes (40) der Unterstation umfasst, wobei das Schaltanlagenfeld vorzugsweise mindestens eines von einem Leistungsschalter, einem Trennschalter, einem Lastschalter oder Lasttrennschalter umfasst, wobei das Betreiben vorzugsweise eine Steueraktion umfasst.

10. Steuerverfahren nach einem der vorhergehenden Ansprüche, ferner umfassend:
- Identifizieren (14), durch die IED (36), einer Nicht-Fehlerbedingung basierend auf den Messdaten, wobei die Nicht-Fehlerbedingung angibt, dass der bedingte Steuerbefehl nicht mehr notwendig ist, und
- Übertragen, durch die IED, eines Abbruchbefehls zum Abbrechen des bedingten Steuerbefehls an die Zusammenführungseinheit.

11. Zusammenführungseinheit (34) für ein Steuersystem einer Unterstation, wobei die Zusammenführungseinheit umfasst:
- eine einspeisungsseitige Schnittstelle zum Empfangen von Messsignalen von mindestens einer Unterstationseinspeisung der Unterstation;
- einen Signalwandler zum Bereitstellen von Messdaten basierend auf den Messsignalen der mindestens einen Unterstationseinspeisung;
- eine BUS-Schnittstelle zum Übertragen der Messdaten über ein BUS-Netzwerk an eine IED und zum Empfangen eines bedingten Steuerbefehls von der IED,
**dadurch gekennzeichnet, dass**
der bedingte Steuerbefehl eine Steuermaßnahme und eine Bedingung für die Ausführung der Steuermaßnahme umfasst; und
dass die Zusammenführungseinheit ferner umfasst:
- Logik, die ausgelegt ist zum Bestimmen (18), ob die Bedingung des bedingten Steuerbefehls erfüllt ist, und falls ja, zum Initiieren (20) der Steuermaßnahme des Unterstationseinspeisungsstromkreises.

12. Steuersystem für eine Unterstation, wobei das Steuersystem umfasst:
- mindestens eine Unterstationseinspeisung (30) mit Sensoren (32) zum Bereitstellen von Messsignalen,
- mindestens eine Zusammenführungseinheit (34) nach Anspruch 11,
- eine IED (36); und
- ein BUS-Netzwerk (38a, 38b), das die mindestens eine Zusammenführungseinheit (34) mit der IED (36) verbindet, wobei
die IED aufweist: eine BUS-Schnittstelle zum Empfangen der Messdaten; Logik zum Identifizieren, basierend auf den Messdaten, einer Fehlerbedingung, die einen potenziell bevorstehenden Fehler angibt, und zum Bereitstellen eines bedingten Steuerbefehls, wobei die BUS-Schnittstelle ausgelegt ist zum Übertragen des bedingten Steuerbefehls über das BUS-Netzwerk an die mindestens eine Zusammenführungseinheit.

13. Steuersystem nach Anspruch 12, wobei das BUS-Netzwerk zwischen der IED und der Zusammenführungseinheit einem hierarchischen Kommunikationsprotokoll entspricht, wobei sich die mindestens eine Zusammenführungseinheit an einer niedrigeren hierarchischen Ebene als die IED innerhalb des hierarchischen Kommunikationsprotokolls befindet.

14. Steuersystem nach Anspruch 12 oder 13, wobei der bedingte Steuerbefehl als ein Codelet codiert ist, und wobei die Zusammenführungseinheit Logik aufweist, die ausgelegt ist zum Ausführen des Codelets.

15. Steuersystem nach einem der Ansprüche 12-14, ferner umfassend mindestens ein Schaltanlagenfeld, wobei das Schaltanlagenfeld vorzugsweise mindestens eines von einem Leistungsschalter, einem Trennschalter, einem Lastschalter oder Lasttrennschalter umfasst, wobei die Steuermaßnahme vorzugsweise eine Steueraktion umfasst.

## Revendications

1. Procédé (100) de commande pour un système de commande dans une sous-station, le système de commande comportant une artère (30) de sous-station, un dispositif électronique intelligent, IED, (36), une unité (34) de fusion, et un réseau (38a, 38b) de BUS reliant l'IED (36) et l'unité (34) de fusion, le procédé de commande comportant :
- la fourniture (10) de signaux de mesures par l'artère (30) de sous-station à l'unité (34) de fusion,
- la transmission (12), par l'unité (34) de fusion, de données de mesures basées sur les signaux de mesures de l'artère de sous-station à l'IED (36) via le réseau (38a, 38b) de BUS,
- l'identification (14), par l'IED (36), d'un état de défaillance d'après les données de mesures, l'état de défaillance étant indicatif d'une défaillance potentiellement à venir,
**caractérisé par** :
- la transmission (16), par l'IED (36), d'une instruction de commande conditionnelle à l'unité (34) de fusion via le réseau (38a, 38b) de BUS, l'instruction de commande conditionnelle comportant une mesure de commande et une condition d'exécution de la mesure de commande,
- le fait de déterminer (18), par l'unité de fusion, si la condition de l'instruction de commande conditionnelle est remplie, et si c'est le cas
- le lancement (20), par l'unité de fusion, de la mesure de commande du circuit d'artère de sous-station.

2. Procédé de commande selon la revendication 1, le système de commande comportant au moins une seconde unité de fusion et au moins une seconde artère de sous-station, le réseau de BUS reliant l'IED et la ou les secondes unités de fusion, le procédé comportant en outre :
- la fourniture de signaux de mesures par la ou les secondes artères de sous-station à la ou aux secondes unités de fusion
- la transmission, par la ou les secondes unités de fusion, de secondes données de mesures basées sur les signaux de mesures de la ou des secondes artères de sous-station à l'IED via le réseau de BUS.

3. Procédé de commande selon l'une quelconque des revendications précédentes, la transmission de l'instruction de commande conditionnelle via le réseau de BUS se conformant à un protocole de communication hiérarchique, l'unité de fusion étant située à un niveau hiérarchique plus bas que l'IED à l'intérieur du protocole de communication hiérarchique.

4. Procédé de commande selon l'une quelconque des revendications précédentes, comportant en outre :
- le codage de la condition de l'instruction de commande conditionnelle dans un fragment de code par l'IED et la transmission du fragment de code par l'IED à l'unité de fusion via le réseau de BUS
- le traitement du fragment de code par l'unité de fusion.

5. Procédé de commande selon l'une quelconque des revendications précédentes, la condition de l'instruction de commande conditionnelle comportant un laps de temps de réaction spécifié jusqu'au lancement de la mesure de protection.

6. Procédé de commande selon l'une quelconque des revendications précédentes, la condition de l'instruction de commande conditionnelle comportant un seuil de défaillance spécifié pour les données de mesures.

7. Procédé de commande selon l'une quelconque des revendications précédentes, la condition de l'instruction de commande conditionnelle comportant un modèle de décision de commande basé sur des données de mesures, le modèle de décision de commande comportant de préférence une condition de passage par zéro pour un courant et/ou une tension mesurés.

8. Procédé de commande selon l'une quelconque des revendications précédentes, les signaux de mesures comportant au moins des signaux parmi des signaux de tension, des signaux de courant, des signaux de température, et des signaux de fréquence.

9. Procédé de commande selon l'une quelconque des revendications précédentes, la mesure de commande comportant la manœuvre d'au moins une cellule (40) d'appareillage de la sous-station, la cellule d'appareillage comportant de préférence au moins un appareil parmi un disjoncteur, un sectionneur, un commutateur de charge ou un interrupteur-sectionneur, la manœuvre comportant de préférence une action de commande.

10. Procédé de commande selon l'une quelconque des revendications précédentes, comportant en outre
- l'identification (14), par l'IED (36), d'un état sans défaillance d'après les données de mesures, l'état sans défaillance étant indicatif du fait que l'instruction de commande conditionnelle n'est plus nécessaire, et
- la transmission, par l'IED, d'une instruction d'annulation pour annuler l'instruction de commande conditionnelle à l'unité de fusion.

11. Unité (34) de fusion pour un système de commande d'une sous-station, l'unité de fusion comportant :
- une interface côté artère servant à recevoir des signaux de mesures en provenance d'au moins une artère de sous-station de la sous-station ;
- un convertisseur de signaux servant à fournir des données de mesures d'après les signaux de mesures de l'artère ou des artères de sous-station ;
- une interface de BUS servant à transmettre les données de mesures à un IED via un réseau de BUS et à recevoir une instruction de commande conditionnelle en provenance de l'IED,
**caractérisé en ce que**
l'instruction de commande conditionnelle comporte une mesure de commande et une condition pour l'exécution de la mesure de commande ; et
**en ce que** l'unité de fusion comporte en outre ;
- une logique configurée pour déterminer (18) si la condition de l'instruction de commande conditionnelle est remplie, et si c'est le cas, pour lancer (20) la mesure de commande du circuit d'artère de sous-station.

12. Système de commande pour une sous-station, le système de commande comportant :
- au moins une artère (30) de sous-station dotée de capteurs (32) destinés à fournir des signaux de mesures,
- au moins une unité (34) de fusion selon la revendication 11,
- un IED (36) ; et
- un réseau (38a, 38b) de BUS reliant l'unité ou les unités (34) de fusion à l'IED (36),
l'IED possédant une interface de BUS pour recevoir les données de mesures; une logique pour identifier, d'après les données de mesures, un état de défaillance indicatif d'une défaillance potentiellement à venir et pour fournir une instruction de commande conditionnelle, l'interface de BUS étant configurée pour transmettre l'instruction de commande conditionnelle, via le réseau de BUS, à l'unité ou aux unités de fusion.

13. Système de commande selon la revendication 12, le réseau de BUS entre l'IED et l'unité de fusion se conformant à un protocole de communication hiérarchique, l'unité ou les unités de fusion étant situées à un niveau hiérarchique plus bas que l'IED à l'intérieur du protocole de communication hiérarchique.

14. Système de commande selon la revendication 12 ou 13, l'instruction de commande conditionnelle étant codée comme un fragment de code, et l'unité de fusion possédant une logique configurée pour exécuter le fragment de code.

15. Système de commande selon l'une quelconque des revendications 12 à 14, comportant en outre au moins une cellule d'appareillage, la cellule d'appareillage comportant de préférence au moins un appareil parmi un disjoncteur, un sectionneur, un commutateur de charge ou un interrupteur-sectionneur, la mesure de commande comportant de préférence une action de commande.
